# EUROPÄISCHE PATENTANMELDUNG

(11) **EP 1 139 105 A2**
(43) Veröffentlichungstag der Anmeldung: **04.10.2001**
(21) Anmeldenummer: 01106815.2
(22) Anmeldetag: 19.03.2001
(51) Int. Cl.: G01R 15/24

(54) **Optischer Stromsensor mit Lichtwellenleiter-Sensoreinheit**

(30) Priorität: 30.03.2000 DE 10015490
(71) Anmelder: SIEMENS AKTIENGESELLSCHAFT, 80333 München (DE)
(72) Erfinder: Amtmann, Karlheinz, 91466 Gerhardshofen (DE); Kull, Volker, 75059 Zaisenhausen (DE); Sperber, Jürgen, 90765 Fürth (DE)

(57) **Zusammenfassung**

Der Stromsensor enthält eine Lichtwellenleiter-Sensoreinheit (2) mit einer Lichtwellenleiter-Spule (21,22,23) für einen elektrischen Leiter. Ein stabilisierter, optischer Transmitter (1) erzeugt Licht konstanter Wellenlänge und speist diese in die Sensoreinheit ein. Ein optischer Empfänger (4) empfängt das Licht nach dem Durchlauf durch die Sensoreinheit und generiert einen elektrischen Messwert (43) für die Größe des Stromes durch den elektrischen Leiter. Der Transmitter weist ein Lichtquellenmodul (11) zur Erzeugung von Licht konstanter Wellenlänge und eine geregelte Ansteuerschaltung (30) auf, welche erste Mittel (32) zur Erzeugung eines konstanten Speisestromes (311) für das Lichtquellenmodul und zweite Mittel (33) zur Stabilisierung der Temperatur im Lichtquellenmodul enthält. Die zweiten Mittel enthalten vorteilhaft einen Temperatursensor (314), einen pulspausenmodulierten Temperaturregler (330) und ein steuerbares Temperatureinstellelement (315), z.B. ein Peltier - Element.

## Beschreibung

Die Erfindung betrifft einen optischen Stromsensor, der mit mindestens einer Lichtwellenleiter-Sensoreinheit ausgerüstet ist. Eine solche Sensoreinheit weist eine Sensorspule aus einem Lichtwellenleiterkabel auf. Durch diese Spule kann ein stromführender elektrischer Leiter hindurchgeführt werden, dessen Stromstärke mit dem optischen Stromsensor erfasst werden soll. Hierzu wird in die Sensorspule monochromes Licht eingespeist, welches möglichst eine Wellenlänge aufweist. Dabei wird die Polarisation des Lichtes abhängig von der Stärke des durch den elektrischen Leiter hindurch fließenden Stromes verändert. Eine Auswertung dieser Polarisationsveränderung ermöglicht einen Rückschluss auf die Stärke des Stromes im elektrischen Leiter.

Bei derartigen Sensoren tritt das Problem auf, dass bereits geringste Schwankungen in der Wellenlänge des in die Sensorspule der Lichtwellenleiter-Sensoreinheit eingespeisten Lichts zu einer Messungenauigkeit bei der Bestimmung der Stärke des Stromes im elektrischen Leiter führen kann.

Der Erfindung liegt die Aufgabe zugrunde, einen optischen Stromsensor anzugeben, bei dem derartige Messungenauigkeiten nicht auftreten.

Die Aufgaben wird gelöst mit dem im Anspruch 1 angegebenen optischen Stromsensor. Vorteilhafte weitere Ausführungsformen sind in den Unteransprüchen angegeben.

Der Vorteil des erfindungsgemäßen Stromsensors liegt darin, dass der optische Transmitter, der Licht mit konstanter Wellenlänge erzeugt und in die Lichtwellenleiter-Sensoreinheit einspeist, und damit ein die Messgenauigkeit des Stromsensors in einem erheblichen Grad mit bestimmendes Element darstellt, stabilisiert ist. Es wird somit nur Licht mit einer Wellenlänge eingespeist, welche einen möglichst konstanten Wert aufweist. Hierdurch wird die Messgenauigkeit bei der Auswertung der durch den Fluss des zu messenden elektrischen Stromes verursachten Änderung in deren Polarisation erheblich verbessert.

In einer bevorzugten Ausführungsform der Erfindung weist der stabilisierte, optische Transmitter zumindest ein Lichtquellenmodul zur Erzeugung von Licht mit konstanter Wellenlänge auf, das von einer geregelten Ansteuerschaltung betrieben wird. Vorteilhaft weist diese geregelte Ansteuerschaltung erste Mittel zur Erzeugung eines konstanten Speisestromes für das Lichtquellenmodul und zweite Mittel zur Stabilisierung der Temperatur im Lichtquellenmodul auf. Mit einer solchen Anordnung kann z.B. monochromes Licht bei einer konstanten Wellenlänge von 820nm erzeugt werden, wobei eine durch Driftabweichungen verursachte Toleranz von maximal + 0,5 nm auftreten kann.

Besonders vorteilhaft ist es, wenn die zweiten Mittel einen Temperatursensor, einen Temperaturregler und ein steuerbares Temperatureinstellelement aufweisen. Insbesondere dann, wenn der Temperaturregler PID- Verhalten aufweist und das Temperatureinstellelement z.B. ein Peltier -Element ist, womit abhängig von den jeweiligen Umweltbedingungen sowohl eine Abkühlung als auch eine Erwärmung erzielbar ist, kann die Temperatur und damit die Wellenlänge des vom Lichtquellenmodul emittierten Lichtes genau konstant gehalten werden.

Besonders vorteilhaft weist der Temperaturregler im optischen Stromsensor Mittel zur pulsweitenmodulierten Vorgabe eines Stellsignals für das steuerbare Temperatureinstellelement auf. Hiermit kann die Temperatur bei geringer Verlustleistung schnell und genau vorgegeben werden.

Die Erfindung wird an Hand der in den nachfolgend kurz angegebenen Figuren enthaltenen Beispielen näher erläutert. Dabei zeigt
- Figur 1:: die wesentlichen Elemente einer bevorzugten Ausführungsform des erfindungsgemäßen optischen Stromsensors in Form eines Blockschaltbildes,
- Figur 2:: eine bevorzugte Ausführungsform für einen stabilisierten, optischen Transmitter gemäß der Erfindung in Form eines Blockschaltbildes, und
- Figur 3:: eine bevorzugte Ausführungsform für die zweiten Mittel im stabilisierten, optischen Transmitter, welche eine Stabilisierung der Temperatur in einem Lichtquellenmodul der erfindungsgemäßen optischen Stromsensoreinheit bewirken.

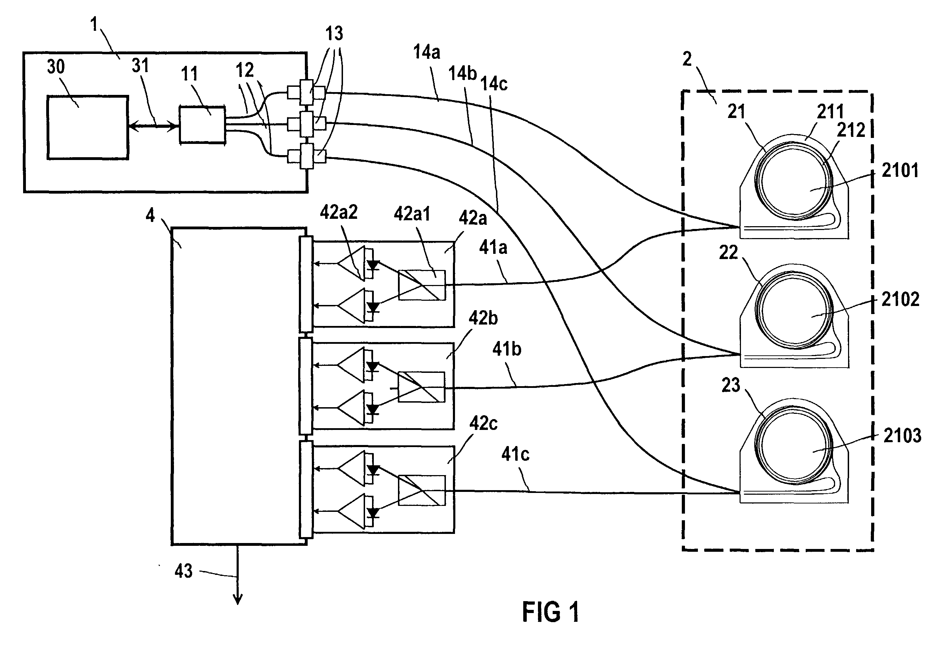

Im Beispiel der Figur 1 sind die wesentlichen Elemente einer bevorzugten Ausführungsform des erfindungsgemäßen optischen Stromsensors in Form eines Blockschaltbildes gezeigt.

Dabei ist beispielhaft eine dreiphasige Lichtwellenleiter-Sensoreinheit 2 gezeigt. Diese weist drei separate Lichtwellenleiter-Sensoren 21,22,23 auf, welche jeweils dem stromführenden, elektrischen Leiter 2101, 2102, 2103, insbesondere eines Dreiphasensystems zugeordnet sind. Dabei weist jeder Lichtwellenleiter-Filter 21,22,23 ein Filtergehäuse auf, beispielhaft der Filter 21 das Gehäuse 211. Jedes Filtergehäuse enthält eine Sensorspule aus Lichtwellenleiterkabel. Im Beispiel der Figur 1 weist das Filtergehäuse 211 die Sensorspule 212 auf. Ferner sind die stromführenden, elektrischen Leiter 2101, 2102, 2103 durch die Gehäuse der Lichtwellenleiter-Sensoren 21,22,23 hindurchgeführt.

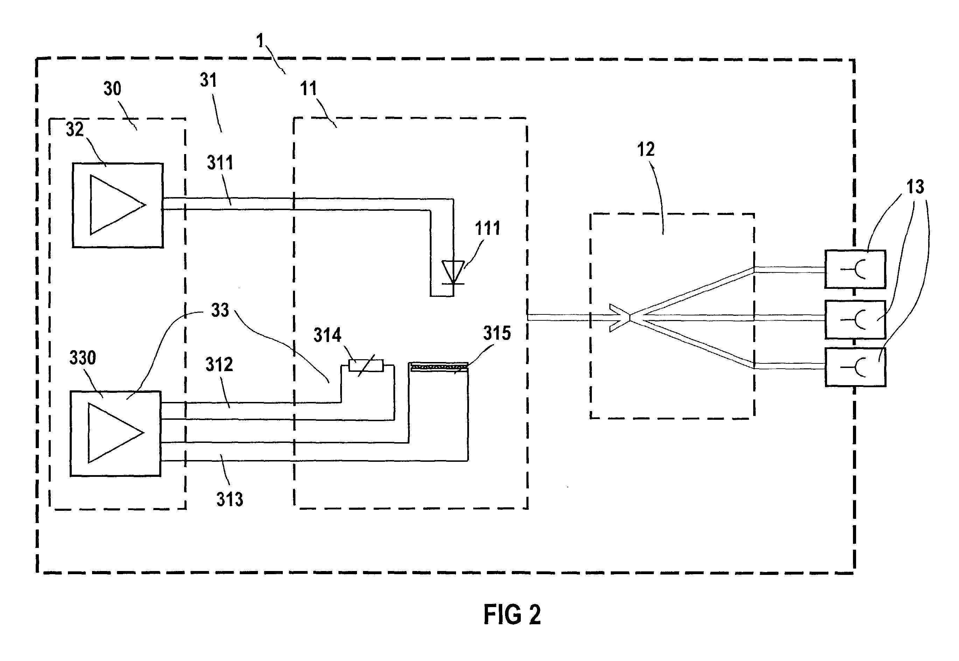

Gemäß der Erfindung wird Licht mit konstanter Wellenlänge von einem stabilisierten, optischen Transmitter 1 generiert und über Lichtwellenleiterkabel 14a, 14b, 14c, die als Zuleitungen dienen, den Lichtwellenleiter-Sensoren 21, 22, 23 zugeführt. Der Transmitter 1 enthält ein Lichtquellenmodul 11 für polarisiertes Licht. Dieses weist wiederum zumindest eine insbesondere integrierte Leuchtdiode 111 auf, z.B. eine Superluminiszenzdiode. Bei einer dreiphasigen Anordnung wird das Licht durch einen nachgeschalteten optischen Splitter 15 von einer auf drei Phasen gesplittet. Dieses Licht wird über optische Zuleitungen 12 und optische Steckverbinder 13 getrennt für jede Phase in die Lichtwellenleiterkabel 14a, 14b, 14c eingespeist. Ferner weist im Beispiel der Figur 1 der stabilisierte, optische Transmitter 1 eine geregelte Ansteuerschaltung 30 auf, welche über Mess- und Steuersignalleitungen 31 mit dem Lichtquellenmodul 11 verbunden ist. Ein vorteilhafter Aufbau eines stabilisierten, optischen Transmitters 1 wird am Beispiel der Figur 2 noch näher erläutert werden.

Nachdem das Licht die Sensorspule 211 eines jeden Lichtwellenleiter-Leiters 21, 22, 23 durchlaufen hat, wird es über weitere Lichtwellenleiterkabel 41a, 41b, 41c einem optischen Empfänger 4 zugeleitet. Dieser weist pro Phase ein Empfangsteil 42a, 42b, 42c auf, in dem das Licht in entsprechende elektrische Signale umgewandelt wird. Hierzu verfügt ein jedes Empfangsteil über ein Polarisationsfilter, in dem das Licht aufgeteilt und einem Paar von optoelektrischen Kopplern, z.B. fotoempfindlichen Elementen bzw. optisch steuerbaren Dioden, zugeführt wird. Diesen sind jeweils Verstärker nachgeschaltet, welche hieraus ein entsprechendes elektrisches Messsignal ableiten. So weist beispielsweise das Empfangsteil 42a ein Polarisationsfilter 42al und einen optoelektrischen Koppler 42a2 auf. Am Ausgang des optischen Empfängers 4 stehen schließlich elektrische Messwerte 43 für die Ströme durch die stromführenden elektrischen Leiter 2101, 2102, 2103 zu Verfügung.

Im Beispiel der Figur 2 ist eine bevorzugte Ausführungsform für einen stabilisierten, optischen Transmitter 1 gemäß der Erfindung in Form eines Blockschaltbildes gezeigt. Dieser enthält beispielsweise eine geregelte Ansteuerschaltung 30 für das Lichtquellenmodul 11, welche erste Mittel zur Erzeugung eines konstanten Speisestromes und zweite Mittel 33 zur Stabilisierung der Temperatur im Lichtquellenmodul 11 aufweist.

Die ersten Mittel zur Erzeugung eines konstanten Speisestromes weisen vorteilhaft einen Konstantstromregler 32 auf. Über eine Zuführung 311 wird der hiervon erzeugte konstante Speisestrom beispielhaft einer integrierten Superluminiszenzdiode 111 im Lichtquellenmodul 11 zugeführt.

Die zweiten Mittel 33 zur Stabilisierung der Temperatur im Lichtquellenmodul 11 weisen einen Temperatursensor 314 und ein Temperatureinstellelement 315 auf. Vorzugsweise sind beide Elemente in das Lichtquellenmodul 11 integriert, können aber in einer anderen, nicht dargestellten Ausführungsform auch von außen auf das Gehäuse des Lichtquellenmoduls 11 aufgesetzt sein. Vorteilhaft ist das steuerbare Temperatureinstellelement 315 ein Peltier - Element, welches abhängig von der Richtung des durchfließenden Stromes eine kühlende bzw. erwärmende Funktion hat. Im Beispiel der Figur 1 ist der Temperatursensor 314 mit einem Temperaturregler 330 über Messsignalleitungen 312 verbunden. Hierüber wird dem Temperaturregler 330 ein Temperaturistwert 330a zugeführt. Ferner ist das Temperatureinstellelement 315 über Steuersignalleitungen 313 mit dem Temperaturregler 330 verbunden. Hierüber gibt der Temperaturregler 330 dem Temperatureinstellelement 315 einen Temperatursollwert 331a vor.

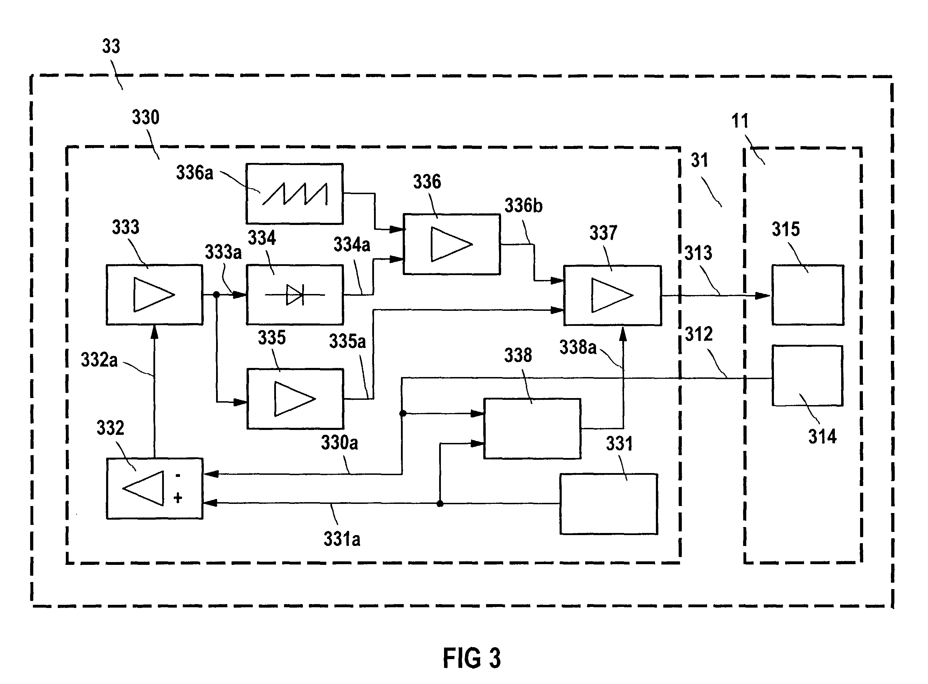

In Figur 3 ist eine bevorzugte Ausführungsform für die zweiten Mittel im stabilisierten, optischen Transmitter gezeigt, welche eine Stabilisierung der Temperatur in einem Lichtquellenmodul der erfindungsgemäßen optischen Stromsensoreinheit bewirken.

Vorteilhaft ist im Beispiel der Figur 3 der Temperaturregler 330 unter Einsatz einer sogenannten Pulsweitenmodulation aufgebaut. Ein Temperaturistwert 330a vom Temperatursensor 314 und ein Temperatursollwert 331a von einer Einrichtung zur Sollwertvorgabe 331, z.B. einem Potentiometer, werden einem Vergleicher 332 zugeführt. Dieser leitet aus den Soll- und Istwerten eine Regelabweichung 332a für die Temperatur im Inneren des Lichtquellenmoduls 11 ab. Die Regelabweichung 332a wird einem Regler 333 zugeführt, bevorzugt einem PID Regler, der hieraus ein analoges Stellsignal 333a bildet.

Das analoge Stellsignal 333a wird einerseits einem Gleichrichter 334 zugeführt, der hieraus den Betrag des Stellsignales 334a ableitet, und einem Vorzeichenverstärker 335, der hieraus das Vorzeichen 335a des analogen Stellsignals 333a ableitet. Der Betrag des Stellsignales 334a wird einem Leistungsstellglied 336 zugeführt. Dieses ist bevorzugt als ein pulsweitenmodulierter Komparator ausgebildet, dem ein Grundsignal von einem Sägezahngenerator 336a zugeführt wird. Durch Überlagerung des dreieckförmigen Signals aus dem Sägezahngenerator 336a und dem Betrag des Stellsignales 334a werden pulsweitenmodulierte, rechteckförmige Stellsignale 336b generiert und einem Endverstärker 337 zugeführt. Dieser bildet die endgültigen Steuersignale für das steuerbare Temperatureinstellelement 315. Das Vorzeichensignal 335a wird ebenfalls dem Endverstärker 337 zugeführt. Dieser wird hierdurch abhängig von den um das Lichtquellenmodul 11 vorliegenden Umgebungsbedingungen so umgeschaltet, dass die Stellsignale eine einstellbare Heizwirkung bzw. Kühlwirkung des steuerbaren Temperatureinstellelements 315 hervorrufen.

Schließlich weist der Temperaturregler 330 von Figur 3 eine Schutzschaltung 338 auf. Dieser bewirkt eine Abschaltung des Endverstärkers 337 über ein Abschaltsignal 338a, wenn die Differenz zwischen dem Temperaturistwert 330a und dem Temperatursollwert 331a einen vorgegebenen Grenzwert überschreitet.

## Patentansprüche

1. Optischer Stromsensor, mit
a) einer Lichtwellenleiter-Sensoreinheit (2), mit mindestens einer Lichtwellenleiter-Spule (21,22,23), welches einem stromführenden elektrischen Leiter (2101,2102,2103) zugeordnet ist,
b) einem stabilisierten, optischen Transmitter (1), der Licht mit konstanter Wellenlänge erzeugt und in die Lichtwellenleiter-Sensoreinheit (2) einspeist, und
c) einem optischen Empfänger (4), der das Licht mit konstanter Wellenlänge nach dem Durchlauf durch die Lichtwellenleiter-Sensoreinheit (2) empfängt und aus dessen Polarisation einen die Größe des Stromes durch den zugeordneten elektrischen Leiter (2101,2102,2103) kennzeichnenden elektrischen Messwert (43).

2. Optischer Stromsensor nach Anspruch 1, **dadurch gekennzeichnet, dass** der stabilisierte, optische Transmitter (1) aufweist
a) zumindest ein Lichtquellenmodul (11) zur Erzeugung von Licht mit konstanter Wellenlänge, und
b) eine geregelte Ansteuerschaltung (30) für das Lichtquellenmodul (11), welche erste Mittel (32) zur Erzeugung eines konstanten Speisestromes (311) für das Lichtquellenmodul (11) und zweite Mittel (33) zur Stabilisierung der Temperatur im Lichtquellenmodul (11) aufweist.

3. Optischer Stromsensor nach Anspruch 2, **dadurch gekennzeichnet, dass** die zweiten Mittel (33) aufweisen
a) einen Temperatursensor (314),
b) einen Temperaturregler (330), und
c) ein steuerbares Temperatureinstellelement (315).

4. Optischer Stromsensor nach Anspruch 3, **dadurch gekennzeichnet, dass** der Temperaturregler (330) Mittel (336,336a) zur pulsweitenmodulierten Vorgabe eines Stellsignals (313) für das steuerbare Temperatureinstellelement (315) aufweist.

5. Optischer Stromsensor nach einem der Ansprüche 3 oder 4, **dadurch gekennzeichnet, dass** das steuerbare Temperatureinstellelement (315) ein Peltier - Element ist.

6. Optischer Stromsensor nach einem der Ansprüche 2 bis 5, **dadurch gekennzeichnet, dass** das Lichtquellenmodul (11) zumindest eine Superluminiszenzdiode enthält.
